(19) **Europäisches Patentamt European Patent Office Office européen des brevets**

(11) **EP 4 343 344 B1**

(12) **FASCICULE DE BREVET EUROPEEN**

(45) Date de publication et mention
de la délivrance du brevet:
**06.05.2026 Bulletin 2026/19**

(21) Numéro de dépôt: **23198427.9**

(22) Date de dépôt: **20.09.2023**

(51) Classification Internationale des Brevets (IPC):
***G01R 31/08*** *(2020.01)*

(52) Classification Coopérative des Brevets (CPC):
**G01R 31/086**

(54) **PROCÉDÉ DE LOCALISATION DE DÉFAUT DANS UN RÉSEAU DE DISTRIBUTION
ÉLECTRIQUE**

VERFAHREN ZUR FEHLERORTUNG IN EINEM ELEKTRISCHEN VERSORGUNGSNETZ

METHOD FOR FAULT LOCATION IN AN ELECTRICAL DISTRIBUTION NETWORK

(84) Etats contractants désignés:
**AL AT BE BG CH CY CZ DE DK EE ES FI FR GB
GR HR HU IE IS IT LI LT LU LV MC ME MK MT NL
NO PL PT RO RS SE SI SK SM TR**

(30) Priorité: **23.09.2022 FR 2209663**

(43) Date de publication de la demande:
**27.03.2024 Bulletin 2024/13**

(73) Titulaires:
• **Electricité de France
75008 Paris (FR)**
• **CentraleSupélec
91190 - Gif-sur-Yvette (FR)**
• **Centre National de la Recherche Scientifique
(CNRS)
75016 Paris (FR)**
• **Université Paris-Saclay
91190 Gif-sur-Yvette (FR)**
• **SORBONNE UNIVERSITE
75006 Paris (FR)**

(72) Inventeurs:
• **SALHAB, Elie
91300 MASSY (FR)**
• **CROTEAU, Dominique
78500 SARTROUVILLE (FR)**
• **LEBOURG, Quentin
91300 MASSY (FR)**
• **PETIT, Marc
91400 ORSAY (FR)**
• **LE, Trung Dung
91940 LES ULIS (FR)**

(74) Mandataire: **Regimbeau
20, rue de Chazelles
75847 Paris Cedex 17 (FR)**

(56) Documents cités:
**EP-A1- 2 045 610     EP-A1- 3 814 788
FR-A1- 3 028 620**

**Description**

**DOMAINE TECHNIQUE**

Le domaine de l'invention est celui des réseaux électriques de distribution d'électricité et plus précisément les réseaux HTA (pour « Haute Tension A », typiquement entre 1kV et 50kV). L'invention concerne plus particulièrement la localisation de défauts monophasés dans de tels réseaux.

**TECHNIQUE ANTÉRIEURE**

Les réseaux HTA sont des réseaux intermédiaires entre les réseaux de Transport HTB (Haute Tension niveau B) et les réseaux BT (Basse Tension) qui arrivent chez les particuliers.

Contrairement aux réseaux HTB qui sont des réseaux maillés, les réseaux HTA sont des réseaux exploités de manière arborescente. Chaque "départ" (partie du réseau constituant un arbre) est alimenté depuis un seul point d'alimentation situé dans un poste de transformation HTB/HTA dit "poste source". Il comporte des transformateurs HTA/BT qui sont les points de livraison au réseau BT.

Ces réseaux deviennent de plus en plus souterrains. Or la localisation d'un défaut affectant un câble enterré nécessite une précision élevée (au mètre près) pour pouvoir creuser le sol au bon endroit et effectuer la réparation du câble.

Ces câbles sont alimentés par des postes sources HTB/HTA dont le neutre est mis à la terre soit par une résistance constante (neutre impédant) soit par une bobine réglable en parallèle avec une résistance (neutre compensé).

Sur les réseaux français principalement souterrains (fortement câblés), le neutre impédant est utilisé. Les paramètres de ces câbles sont généralement mal estimés ou bien négligés, ce qui conduit à des erreurs de localisation de défaut.

Sur les réseaux à neutre compensé (constitués généralement d'une partie aérienne et d'une partie souterraine), cette localisation devient encore plus difficile à cause de la faible amplitude du courant de défaut à la fréquence industrielle (50 Hz). De plus, ces réseaux comportent de nombreuses ramifications (spécifiquement pour les réseaux ruraux) et il faut donc déterminer dans quelle ramification se situe le défaut. Une solution adoptée par le gestionnaire du réseau est de déployer des indicateurs de passage de défauts en différents endroits du réseau afin d'identifier une zone restreinte dans laquelle se situe le défaut. Cependant, certains indicateurs ne fonctionnent pas correctement (contraintes environnementales, paramétrage) et restent trop coûteux pour envisager de les déployer/remplacer massivement en différents endroits du réseau.

Il est donc nécessaire de disposer d'une technique permettant de localiser très finement un défaut souterrain pour les deux types de réseau (neutre impédant et neutre compensé). De plus, pour les réseaux compensés et fortement ramifiés, il est nécessaire de pouvoir identifier la bonne ramification en défaut sans devoir installer de nouveaux indicateurs de passage de défaut ni ajouter des mesures dispersées dans différents endroits du réseau.

Certaines études portant sur des réseaux à neutre impédant considèrent des hypothèses simplificatrices ce qui rend l'estimation des paramètres du réseau et la localisation du défaut imparfaites. De plus, afin d'estimer le courant de défaut, ces études nécessitent de réaliser des mesures en tête de chaque départ du poste source ainsi qu'au niveau du point neutre du poste source, ou bien d'appliquer des approximations permettant de simplifier le modèle du réseau. On pourra à cet égard se référer à :

- R. Marguet and B. Raison, "Fault distance localization method for heterogeneous distribution networks," 2014 IEEE PES General Meeting | Conference & Exposition, 2014, pp. 1-5, doi: 10.1109/PESGM.2014.6939025;
- T. D. Le and M. Petit, "Earth fault location based on a Modified Takagi Method for MV distribution networks," 2016 IEEE International Energy Conference (ENERGYCON), 2016, pp. 1-6, doi: 10.1109/ENERGYCON.2016.7513910.

Le brevet FR 3 028 620 B1 expose quant à lui une technique de localisation dans un réseau à neutre compensé qui utilise un seul point de mesure et une fréquence d'échantillonnage de 10 MHz. Mais, d'une part, la valeur de cette fréquence exige des équipements de mesure assez puissants indisponibles dans les postes sources actuels. Et, d'autre part, cette technique fournit plusieurs solutions pour un même défaut et les erreurs de localisation, qui dépassent la précision d'un mètre, sont non négligeables.

**EXPOSÉ DE L'INVENTION**

L'invention a pour objectif de proposer une technique qui, au moyen de mesures réalisées uniquement en tête du départ en défaut, puisse permettre de localiser très finement le défaut et ce pour les différents régimes de neutre.

A cet effet, l'invention concerne un procédé de localisation d'un défaut affectant une phase d'un départ en défaut d'un réseau de distribution électrique, comprenant les étapes d'obtention d'un signal électrique au moment du défaut, le signal électrique étant mesuré à un poste source du réseau uniquement pour le départ en défaut, et d'examen de tronçons du départ en défaut, chaque tronçon ayant une tête et une queue. L'examen d'un tronçon comprend l'estimation, à partir du signal électrique obtenu, d'un courant de défaut au niveau de la queue du tronçon, le calcul d'une distance du défaut depuis la tête du tronçon, le calcul d'un écart entre la distance estimée et une longueur séparant la tête de la queue du tronçon et, en fonction dudit écart, l'identification ou non d'une solution de localisation du défaut.

Certains aspects préférés mais non limitatifs de ce procédé sont les suivants :

- l'obtention d'un signal électrique au moment du défaut comprend l'obtention, au niveau du poste source, de mesures des courants et tensions pour les trois phases du départ en défaut et l'application d'une transformation de Fortescue aux mesures pour obtenir des valeurs de composantes symétriques au niveau du poste source ;
- l'examen d'un tronçon comprend l'utilisation d'un modèle matriciel du réseau pour, à partir des valeurs des composantes symétriques au niveau du poste source, estimer :

  ○ la tension et le courant de la phase affectée du défaut au niveau de la tête du tronçon ;
  ○ un courant homopolaire au niveau de la tête du tronçon ; et
  ○ les composantes symétriques en amont et en aval de la queue du tronçon.

- l'examen d'un tronçon comprend l'estimation d'un courant de défaut à partir des composantes symétriques en amont et en aval de la queue du tronçon et l'estimation de la distance du défaut depuis la tête du tronçon est réalisée à partir de la tension et du courant de la phase en défaut au niveau de la tête du tronçon, du courant homopolaire au niveau de la tête du tronçon et du courant de défaut estimé ;
- l'estimation du courant de défaut est réalisée à partir des composantes symétriques homopolaires en amont et en aval du défaut ;
- l'examen d'un tronçon comprend en outre une estimation d'une résistance de défaut à partir de la tension et du courant de la phase en défaut au niveau de la tête du tronçon, du courant homopolaire au niveau de la tête du tronçon, du courant de défaut estimé et de la distance estimée du défaut ;
- le réseau est un réseau à neutre compensé, et le procédé comprend en outre :

  ○ l'estimation, pour chaque tronçon du départ en défaut pour lequel une solution de localisation du défaut est identifiée, d'une première résistance de défaut à une fréquence fondamentale du réseau et d'une deuxième résistance de défaut à une fréquence dominante d'oscillations transitoires lors de l'apparition du défaut ;
  ○ la localisation du défaut à partir de la solution de localisation du défaut identifiée pour le tronçon présentant le plus faible écart entre la première et la deuxième résistance de défaut.

## BRÈVE DESCRIPTION DES DESSINS

D'autres aspects, buts, avantages et caractéristiques de l'invention apparaîtront mieux à la lecture de la description détaillée suivante de formes de réalisation préférées de celle-ci, donnée à titre d'exemple non limitatif, et faite en référence aux dessins annexés sur lesquels :

- la figure 1 illustre le parcours itératif, tronçon par tronçon, d'un départ en défaut ;
- la figure 2 illustre différents modèles de quadripôle ;
- la figure 3 illustre un schéma électrique équivalent adopté pour calculer le courant de défaut en queue d'un tronçon ;
- la figure 4 illustre un cas d'étude d'un réseau à neutre compensé ;
- la figure 5 illustre un cas d'étude d'un réseau à neutre impédant.

## EXPOSÉ DÉTAILLÉ DE MODES DE RÉALISATION PARTICULIERS

L'invention propose un procédé de localisation d'un défaut affectant une phase d'un départ en défaut d'un réseau de distribution électrique. Elle s'applique en particulier, mais non exclusivement, aux réseaux HTA ayant une valeur nominale de tension entre 1kV et 50kV.

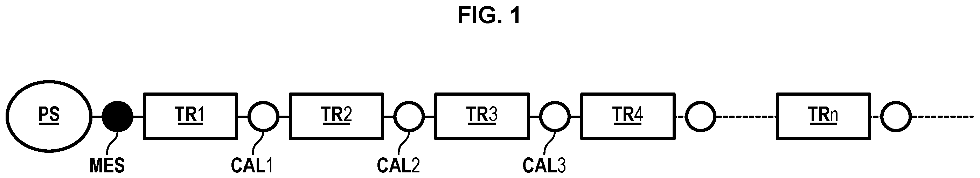

En référence à la figure 1, l'invention cherche à localiser un défaut monophasé dans une structure arborescente appelée « départ » en aval d'un poste source PS alimentant le départ, et à préciser la distance du défaut par rapport au point de mesure (ainsi que fournir une valeur de résistance du défaut comme on le verra dans une forme de réalisation). Pour ce faire, l'invention découpe le départ en une succession de tronçons TR1, TR2, TR3, TR4, ..., TRn formant une arborescence. Chaque tronçon comprend une tête et une queue, la queue d'un tronçon pouvant former la tête d'un tronçon suivant. La distance séparant la tête de la queue d'un tronçon peut être identique pour l'ensemble des tronçons.

Comme illustré sur la figure 1, le réseau comporte, en tête du départ en défaut au niveau d'un point de mesure MES, un ou plusieurs capteurs de signaux électriques reliés à un appareil pour la mise en œuvre de l'invention.

Le procédé selon l'invention comprend une première étape S1 d'obtention d'un signal électrique au moment du défaut, le signal électrique étant mesuré au poste source PS du réseau uniquement pour le départ en défaut au moyen du ou des capteurs susmentionnés.

Cette étape S1 peut notamment comprendre l'obtention de mesures en un point du départ des tensions simples et des courants de phase juste après l'occurrence d'un défaut. Pour ce faire, le réseau est surveillé pour chacune des trois phases du départ en défaut et l'appareil pour la mise en œuvre de l'invention reçoit du poste source PS des signaux de tension et courant sur les trois phases. Ces signaux sont stockés dans une mémoire tampon de l'appareil. Ces signaux sont synchronisés ou horodatés. En cas de détection d'un défaut affectant l'une des phases du départ, ces signaux sont extraits de la mémoire tampon et soumis au traitement qui sera décrit par la suite.

Lorsque le réseau est du type à neutre impédant, les mesures peuvent être enregistrées depuis l'instant d'apparition du défaut et sur une durée de 100 ms. Une fréquence d'échantillonnage d'un kHz est suffisante.

Lorsque le réseau est du type à neutre compensé, les mesures peuvent être enregistrées depuis l'instant d'apparition du défaut et sur une durée de 100 ms. La fréquence d'échantillonnage est de préférence supérieure à 5 kHz.

Le procédé selon l'invention se poursuit avec une étape S2 d'examen des tronçons TR1, TR2, TR3, TR4, ..., TRn du départ en défaut. L'examen d'un tronçon comprend l'estimation, à partir du signal électrique obtenu, d'une distance du défaut depuis la tête du tronçon, le calcul d'un écart entre la distance estimée et une longueur séparant la tête de la queue du tronçon et, en fonction dudit écart, l'identification ou non d'une solution de localisation du défaut.

L'estimation, à partir du signal électrique obtenu, d'une distance du défaut depuis la tête du tronçon peut comprendre l'estimation du courant de défaut au niveau de la queue du tronçon (cette estimation est symbolisée par les références CAL1, CAL2, CAL3 sur la figure 1) et l'exploitation de la méthode de Takagi de détermination de la distance de défaut.

La méthode de Takagi repose sur l'équation suivante (équation 1), utilisée pour un départ homogène. Les grandeurs de cette équation sont utilisées en forme complexe et à une fréquence donnée.

$$V_s = R_f \times I_f + x \times z_\mathrm{d} \times \left( I_s + \frac{z_\mathrm{ho} - z_\mathrm{d}}{z_\mathrm{d}} I_\mathrm{ho} \right) \quad (1)$$

où $V_s$ et $I_s$ sont la tension et le courant de la phase en défaut mesurés (pour le tronçon immédiatement à la sortie du poste source) ou calculés (pour les tronçons suivants) en tête d'un tronçon du départ en défaut, $R_f$ et $I_f$ sont la résistance et le courant de défaut, $x$ est la distance entre la tête du tronçon et le défaut (km), $z_\mathrm{d}$ et $z_\mathrm{ho}$ sont les impédances directe et homopolaire par unité de longueur (Ω/km), et $I_\mathrm{ho}$ est le courant homopolaire mesuré (pour le tronçon immédiatement à la sortie du poste source) ou calculé (pour les tronçons suivants) en tête du tronçon .

En multipliant les deux membres de l'égalité par le complexe conjugué de $I_f$, noté $\hat{I}_f^*$ , et en prenant la partie imaginaire du résultat, on trouve l'équation de localisation (équation 2). Le courant $\hat{I}_f$ dans cette équation est une estimation du courant de défaut $I_f$ dont un calcul sera détaillé par la suite.

$$x = \frac{Im\left(V_s \times \hat{I}_f^*\right)}{Im\left(z_\mathrm{d} \times (I_s + \frac{z_\mathrm{ho} - z_\mathrm{d}}{z_\mathrm{d}} I_\mathrm{ho}) \times \hat{I}_f^*\right)} \quad (2)$$

L'équation de Takagi est utilisée pour des départs homogènes. C'est pour cela que le départ hétérogène en défaut est dans l'invention décomposé en une succession de tronçons homogènes. Le processus de recherche du défaut consiste alors à appliquer la localisation (équation 2) tronçon après tronçon, chacun des tronçons présentant par exemple une longueur (séparant leur tête de leur queue) d'un mètre.

Le premier tronçon peut être immédiatement à la sortie du poste source. Dans un mode de réalisation alternatif, si un indicateur de passage de défaut est installé dans le réseau et signale la présence d'un défaut à la télé-conduite, le premier tronçon est alors situé immédiatement après le nœud où le capteur est installé.

Dans l'invention, la résolution de l'équation 2 dans le plan imaginaire nécessite de disposer :

- de la tension $V_s$ et du courant $I_s$ de la phase en défaut au niveau de la tête du tronçon ;
- du courant homopolaire $I_\mathrm{ho}$ au niveau de la tête du tronçon ; et
- du courant de défaut $I_f$ au niveau de la queue du tronçon.

On relèvera que la résolution de cette équation pour la détermination de la distance du défaut ne nécessite pas de disposer d'une estimation de la résistance de défaut.

Une réalisation possible de l'obtention de ces valeurs est la suivante. Tout d'abord, l'étape S1 comprend l'obtention, au niveau du poste source, de mesures des courants et tensions pour les trois phases du départ en défaut et l'application d'une transformation de Fortescue aux mesures pour obtenir des valeurs de composantes symétriques au niveau du poste source. Puis l'examen d'un tronçon à l'étape S2 comprend l'utilisation d'un modèle matriciel du réseau pour, à partir des valeurs des composantes symétriques au niveau du poste source, estimer les valeurs nécessaires à la résolution de l'équation 2 listées ci-dessus.

Lorsque le réseau est du type à neutre impédant, les composantes symétriques peuvent être déterminées à la fréquence fondamentale $f_0$ du réseau sur la base des mesures enregistrées durant le régime permanent du défaut, soit 4 à 5 périodes après l'apparition du défaut.

Lorsque le réseau est du type à neutre compensé, les composantes symétriques peuvent être déterminées à une fréquence dominante $f_k$ d'oscillations transitoires lors de l'apparition du défaut, sur la base des mesures enregistrées durant le régime transitoire du défaut, par exemple sur une durée de 100 ms suivant l'instant d'apparition du défaut. Toutefois, si le défaut est permanent et les grandeurs électriques sont enregistrées entre les instants 500 et 600 ms après l'apparition du défaut, il convient alors de calculer les composantes symétriques à la fréquence fondamentale durant cet intervalle de temps.

La détermination de la fréquence dominante $f_k$ peut comprendre une décomposition de Prony de la tension homopolaire et du courant homopolaire en plusieurs signaux pseudo-amortis, chacun représenté par les quatre composantes suivantes : amplitude, amortissement, fréquence et déphasage. La fréquence dominante $f_k$ correspond alors à la fréquence dont l'amplitude de la puissance homopolaire associée est la plus grande.

Chaque variable (3 tensions simples, 3 courants de phase) peut alors être exprimée sous forme complexe, provenant de la décomposition de Prony à la fréquence dominante $f_k$ et à la fréquence fondamentale $f_0$ suivant les formules : $s_k(t) = A_k e^{-\alpha_k t} e^{j(2\pi f_k t + \theta_k)}$ et $s_0(t) = A_0 e^{-\alpha_0 t} e^{j(2\pi f_0 t + \theta_0)}$. Sur la base de ces variables, les composantes symétriques (directe, inverse et homopolaire) à la fréquence $f_k$ et $f_0$ des tensions et courants au point de mesure sont calculées.

L'utilisation d'un modèle matriciel du réseau permet, à partir des valeurs des composantes symétriques au niveau du poste source, d'estimer les valeurs nécessaires à la résolution de l'équation 2 en venant recalculer les grandeurs électriques ($V_s$, $I_s$ et $I_{ho}$) et le courant de défaut ($\hat{I}_f$) à chaque pas (1 mètre par exemple) en faisant le parcours du réseau par application de la théorie des quadripôles. Le réseau électrique est modélisé par un bloc contenant quatre connexions d'entrée et quatre de sortie, nommé octopôle. Grâce à la transformation de Fortescue, une chaîne d'octopôles peut être transformée en trois quadripôles indépendants (deux entrées et deux sorties).

Chaque quadripôle représente une matrice 2×2 qui relie l'entrée et la sortie :

$$\begin{bmatrix} V_s \\ I_s \end{bmatrix} = B \times \begin{bmatrix} V_e \\ I_e \end{bmatrix} = \begin{bmatrix} b_{11} & b_{12} \\ b_{21} & b_{22} \end{bmatrix} \times \begin{bmatrix} V_e \\ I_e \end{bmatrix}.$$

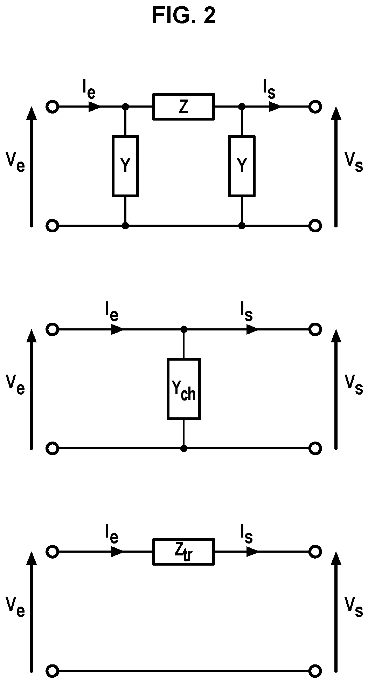

Lorsqu'un élément de réseau est de type conducteur (ligne ou câble) comme représenté en haut de la figure 2, la matrice B s'exprime selon $\begin{bmatrix} 1 + Y \times Z & -Z \\ -2 \times Y - Y^2 \times Z & 1 + Y \times Z \end{bmatrix}$. Lorsqu'un élément de réseau est de type charge comme représenté au centre de la figure 2, la matrice B s'exprime selon $\begin{bmatrix} 1 & 0 \\ -Y_{ch} & 1 \end{bmatrix}$. Lorsqu'un élément de réseau est de type transformateur comme représenté en bas de la figure 2, la matrice B s'exprime selon $\begin{bmatrix} 1 & -Z_{Tr} \\ 0 & 1 \end{bmatrix}$.

En ayant connaissance de grandeurs linéiques (en Ω/km, Farad/km, etc...), il est possible d'adopter les formulations généralisées suivantes qui, parce qu'elles intègrent la longueur *longueur* de l'élément de réseau considéré, s'appliquent pour une ligne, un tronçon d'une ligne, etc. :

- $Z = (R + jLw_0) * longueur$; $Y = \left(\dfrac{jCw_0}{2}\right) * longueur$; $Y_{ch} = \dfrac{1}{R_{ch} + jL_{ch}w_o}$; $Z_{Tr} = (R_{Tr} + jL_{Tr}w_0) * longueur$ (cas du neutre impédant), et

- $Z = (R + jLw_k - L\alpha_k) * longueur$; $Y = \left(\dfrac{jCw_k}{2} - \dfrac{C}{2}\alpha_k\right) * longueur$; $Y_{ch} = \dfrac{1}{R_{ch} + jL_{ch}w_K - L_{ch}\alpha_k}$; $Z_{Tr} = (R_{Tr} + jL_{Tr}w_k - L_{Tr}\alpha_k) * longueur$ (cas du neutre compensé)

Les matrices B de chaque élément du réseau sont établies à partir de la connaissance de la topologie et des caractéristiques des composants du réseau. Il est possible de brancher plusieurs quadripôles montés en série ou en parallèle, et de représenter cette structure par un seul quadripôle équivalent. Cela permet alors de créer une relation entre les mesures d'entrée et de sortie d'un ensemble d'éléments du réseau.

En partant sur la théorie des quadripôles, l'ensemble des éléments situés en aval de la queue d'un tronçon (là où l'on recherche la présence d'un défaut) peut être réduit en un simple bloc $B_{aval}$. Le tronçon en question (où le défaut est considéré sur sa queue) peut quant à lui être représenté par un simple bloc $B_{amont}$.

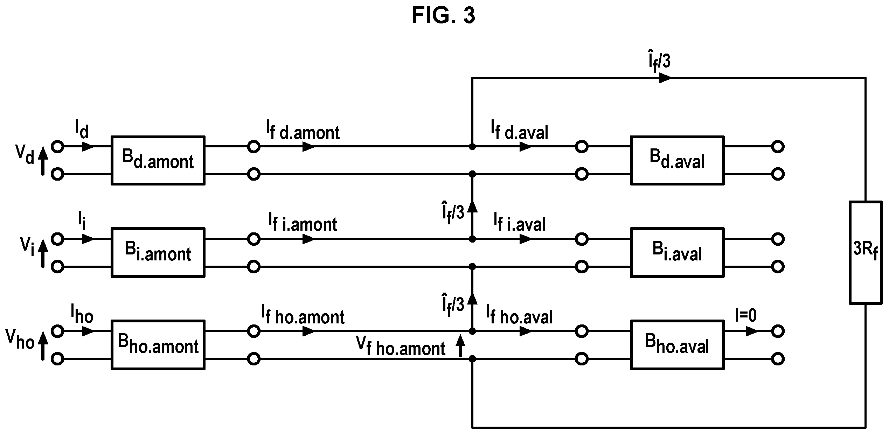

Le schéma monophasé équivalent de ces blocs $B_{amont}$ et $B_{aval}$ dans la base des composantes symétriques dans le cas des défauts monophasés est illustré sur la **Erreur ! Source du renvoi introuvable.**figure 3, où :

- $V_d$, $V_i$ et $V_{ho}$ représentent la tension directe, la tension inverse et la tension homopolaire au niveau de la tête du tronçon considéré en défaut ;
- $I_d$, $I_i$ et $I_{ho}$ représentent le courant direct, le courant inverse et le courant homopolaire au niveau de la tête du tronçon considéré en défaut ;
- Les matrices $B_{d,amont}$ et $B_{d,aval}$ représentent des fonctions de transfert dans le schéma direct associées respectivement au tronçon considéré en défaut et à la partie du départ en aval du défaut ;
- Les matrices $B_{i,amont}$ et $B_{i,aval}$ représentent des fonctions de transfert dans le schéma inverse associées respectivement au tronçon considéré en défaut et à la partie du départ en aval du défaut ;
- Les matrices $B_{ho,amont}$ et $B_{ho,aval}$ représentent des fonctions de transfert dans le schéma homopolaire associées respectivement au tronçon considéré en défaut et à la partie du départ en aval du défaut ;
- $V_{f\,ho,amont}$ représente la tension homopolaire à proximité amont du défaut;
- $V_{f\,i,amont}$ représente la tension inverse à proximité amont du défaut;
- $I_{f\,d,amont}$ et $I_{f\,d,aval}$ représentent respectivement le courant direct à proximité amont et aval du défaut ;
- $I_{f\,i,amont}$ et $I_{f\,i,aval}$ représentent respectivement le courant inverse à proximité amont et aval du défaut ;
- $I_{f\,ho,amont}$ et $I_{f\,ho,aval}$ représentent respectivement le courant homopolaire à proximité amont et aval du défaut ;
- $R_f$ représente la résistance de défaut

On notera que l'utilisation de ces matrices pour l'estimation du courant de défaut au niveau de la queue d'un tronçon permet en outre de déterminer les valeurs de $V_s$, $I_s$ et $I_{ho}$ au niveau de la queue du tronçon, c'est-à-dire à la tête du tronçon suivant.

En appliquant la loi des nœuds au point du défaut, on peut écrire les deux équations suivantes : $\hat{I}_f = 3 \times (I_{fho,amont} - I_{f\,ho,aval})$ et $\hat{I}_f = 3 \times (I_{f\,i,amont} - I_{f\,i,aval})$.

Les deux termes après l'égalité peuvent être déterminés à partir des équations suivantes :

$$V_{f\,ho,amont} = B_{ho,amont}(1,1) \times V_{ho} + B_{ho,amont}(1,2) \times I_{ho}$$

$$V_{f\,i,amont} = B_{i,amont}(1,1) \times V_i + B_{i,amont}(1,2) \times I_i$$

$$I_{f\,ho,amont} = B_{ho,amont}(2,1) \times V_{h0} + B_{ho,amont}(2,2) \times I_{ho}$$

$$I_{f\,i,amont} = B_{i,amont}(2,1) \times V_i + B_{i,amont}(2,2) \times I_i$$

$$I_{f\,ho,aval} = -\frac{B_{ho,aval}(2,1)}{B_{ho,aval}(2,2)} \times V_{f\,ho,amont}$$

$$= -\frac{B_{ho,aval}(2,1)}{B_{ho,aval}(2,2)} * \{B_{ho,amont}(1,1) \times V_{ho} + B_{ho,amont}(1,2) \times I_{ho}\}$$

$$I_{f\,i,aval} = -\frac{B_{i,aval}(2,1)}{B_{i,aval}(2,2)} \times V_{f\,i,amont}$$

$$= -\frac{B_{i,aval}(2,1)}{B_{i,aval}(2,2)} * \{B_{i,amont}(1,1) \times V_i + B_{i,amont}(1,2) \times I_i\}$$

On utilise de préférence les grandeurs homopolaires pour estimer le courant de défaut $\hat{I}_f$ à la fréquence fondamentale dans le cas du neutre impédant et à la fréquence dominante dans le cas du neutre compensé. Toutefois, dans le cas du neutre compensé, si aucun producteur décentralisé n'est raccordé sur le départ en défaut, il peut être plus avantageux d'estimer le courant de défaut à la fréquence fondamentale en utilisant les grandeurs inverses.

Une fois la distance estimée à l'aide de l'équation 2, l'écart séparant cette distance de la longueur séparant la tête de la queue du tronçon est calculé et, en fonction dudit écart, une solution de localisation du défaut est ou non identifiée dans le tronçon examiné. Par exemple, une solution de localisation est identifiée lorsque $a * L \leq x_{est} \leq b * L$, avec $x_{est}$ la distance estimée, $L$ la longueur du tronçon, a et b deux pondérations telles que b>a. On peut par exemple choisir, a=0 et b=1 et ainsi identifier une solution de localisation uniquement lorsque la distance estimée est inférieure à la longueur du tronçon. On peut également choisir a et b tels que $x_{est} \geq -\Delta_x$ ou encore $x_{est} \leq L + \Delta_x$ avec $\Delta_x$ un seuil de tolérance qui peut s'exprimer comme une fraction de L.

Dans une forme de réalisation possible de l'invention, une fois une solution de localisation du défaut identifiée dans un tronçon, le procédé comprend l'estimation de la résistance de défaut. Celle-ci est donnée par l'équation suivante :

$$R_f = \frac{V_s - x \times z_d \times (I_s + \frac{z_{ho} - z_d}{z_d} I_{ho})}{\hat{I}_f}$$

Pour les réseaux à neutre impédant, on utilise les grandeurs électriques à la fréquence $f_0$. Pour les réseaux à neutre compensé, on utilise la fréquence $f_k$ utilisée pour la recherche de défaut.

L'examen des tronçons peut conduire à l'identification de plusieurs solutions de localisation du défaut, parmi lesquelles une seule est la bonne.

Pour les réseaux à neutre impédant (généralement constitués d'un faible nombre de ramifications), il est suffisant de mettre un indicateur de passage de défaut en tête de chaque ramification pour signaler le passage d'un défaut. Dans ce cas, le bon endroit du défaut correspond à la ramification qui a vu le défaut.

Cependant, pour le cas des réseaux compensés (généralement très ramifiés), le nombre d'indicateurs de passage de défaut à déployer serait élevé. Ainsi dans un mode de réalisation possible, le procédé selon l'invention comprend la détermination de la bonne ramification en défaut selon la procédure suivante.

Une nouvelle estimation de la résistance du défaut pour chaque solution trouvée est réalisée en se basant cette fois ci sur les grandeurs symétriques calculées à la fréquence fondamentale $f_0$ (50 Hz). Le courant de défaut est estimé dans ce cas en utilisant soit les grandeurs homopolaires, soit les grandeurs inverses. Le défaut est alors localisé à partir de la solution de localisation identifiée pour le tronçon présentant le plus faible écart entre les valeurs de résistances obtenues à la fréquence $f_k$ et $f_0$.

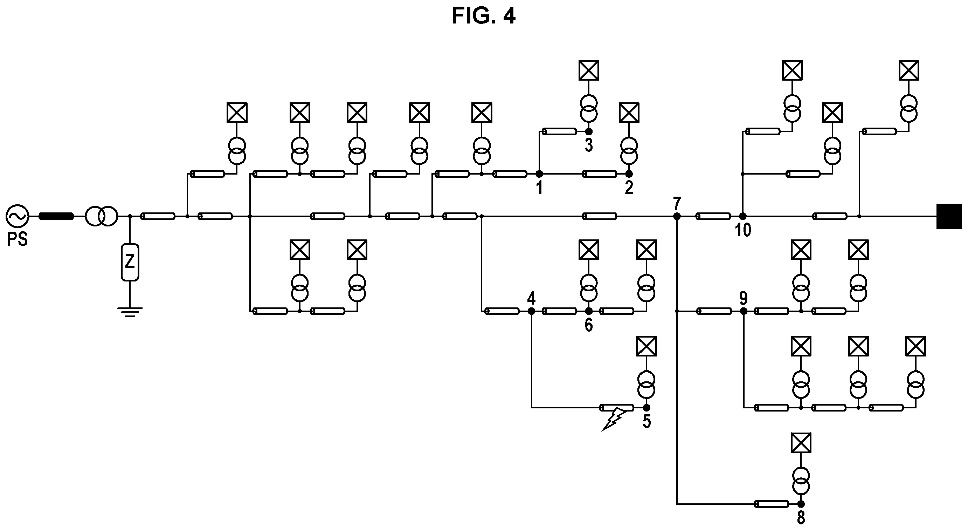

On a représenté sur la figure 4 un cas d'étude pour un réseau à neutre compensé présentant de nombreuses ramifications. Un défaut franc est simulé à 3950 mètres du poste (entre les nœuds 4 et 5). En appliquant les premières étapes du procédé proposée pour le cas du neutre compensé, on trouve tout d'abord 7 solutions de localisation de défaut :

- Entre les nœuds 1 et 2 avec une distance de 3766 m du poste
- Entre les nœuds 1 et 3 avec une distance de 3766 m du poste
- Entre les nœuds 4 et 5 avec une distance de 3951 m du poste
- Entre les nœuds 4 et 6 avec une distance de 3916 m du poste
- Entre les nœuds 7 et 8 avec une distance de 3980 m du poste
- Entre les nœuds 7 et 9 avec une distance de 3984 m du poste
- Entre les nœuds 7 et 10 avec une distance de 3987 m du poste

L'étape suivante consiste à calculer l'écart absolu $|\Delta R|$ des résistances de défauts obtenues à la fréquence $f_k$ et $f_0$ pour chacune des 7 solutions trouvées. On obtient :

- Entre les nœuds 1 et 2, $|\Delta R|$ = 0,395 $\Omega$
- Entre les nœuds 1 et 3, $|\Delta R|$ = 0,395 $\Omega$
- Entre les nœuds 4 et 5, $|\Delta R|$ = 0,005 $\Omega$
- Entre les nœuds 4 et 6, $|\Delta R|$ = 0.009 $\Omega$
- Entre les nœuds 7 et 8, $|\Delta R|$ = 0.257 $\Omega$
- Entre les nœuds 7 et 9, $|\Delta R|$ = 0.263 $\Omega$
- Entre les nœuds 7 et 10, $|\Delta R|$ = 0.269 $\Omega$

Le défaut se situe alors à 3951 m du poste, entre les nœuds 4 et 5.

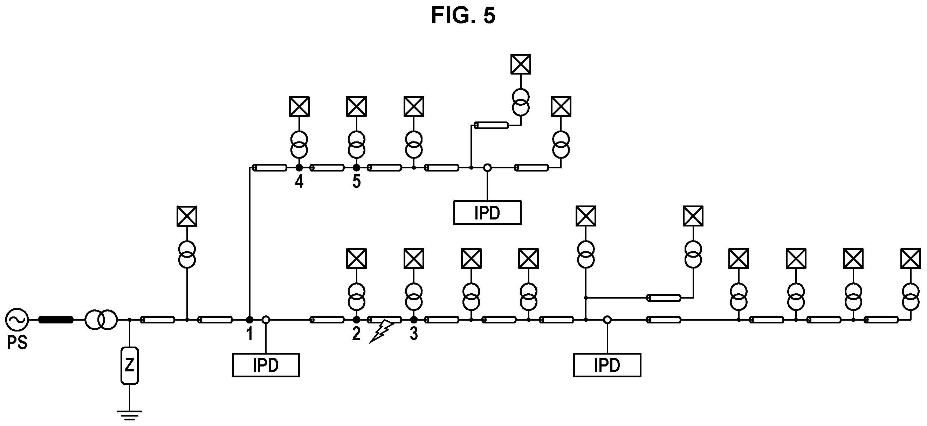

On a représenté sur la figure 5 un cas d'étude pour un réseau à neutre impédant présentant peu de ramifications. Un défaut franc est simulé à 2600 mètres du poste (entre les nœuds 2 et 3). Un indicateur de passage de défaut IPD placé en aval du nœud 1 envoie un signal vers le centre de conduite indiquant la présence d'un défaut sur la partie aval de la branche inférieure. La recherche du défaut est alors effectuée en partant du nœud 1 directement vers le nœud 2. Une seule solution de localisation est identifiée : entre les nœuds 2 et 3 à une distance de 2600 m du poste.

On relèvera que l'invention n'utilise que des mesures déjà effectuées dans les postes sources, spécifiquement en tête du départ en défaut, et est donc simple à implémenter dans un processus opérationnel, sans engendrer de surcoût par l'installation d'équipement supplémentaire sur le terrain. Elle peut prendre la forme d'un logiciel installé dans les postes sources ou dans des systèmes d'informations centralisés. Par ailleurs, le fait de pouvoir localiser rapidement et précisément le défaut, limite les temps de coupure des clients et donc les pénalités sur le distributeur d'électricité. En outre, la localisation au mètre près sur les câbles souterrains permet de limiter, voire de supprimer, l'utilisation de camions de localisation de défauts, dont la maintenance est coûteuse.

L'invention n'est pas limitée au procédé tel que précédemment décrit mais s'étend également à un produit programme d'ordinateur comprenant des instructions qui, lorsque le programme est exécuté par un ordinateur, conduisent celui-ci à mettre en œuvre le procédé précédemment décrit, à un appareil de localisation d'un défaut d'un réseau de distribution électrique, comprenant un processeur configuré pour mettre en œuvre le procédé précédemment décrit ainsi qu'à un poste de transformation électrique comprenant un appareil.

**Revendications**

1. Procédé de localisation d'un défaut affectant une phase d'un départ en défaut d'un réseau de distribution électrique, comprenant les étapes suivantes :

    - obtention d'un signal électrique au moment du défaut, le signal électrique étant mesuré (MES) à un poste source (PS) du réseau uniquement pour le départ en défaut ;
    - examen de tronçons (TR1, TR2, TR3, TR4, TRn) du départ en défaut, chaque tronçon ayant une tête et une queue et l'examen d'un tronçon comprenant :

        ◦ à partir du signal électrique obtenu, l'estimation d'un courant de défaut au niveau de la queue du tronçon et le calcul d'une distance du défaut depuis la tête du tronçon ;
        ◦ le calcul d'un écart entre la distance calculée et une longueur séparant la tête de la queue du tronçon et ;
        ◦ en fonction dudit écart, l'identification ou non d'une solution de localisation du défaut.

2. Procédé selon la revendication 1, dans lequel l'étape d'obtention d'un signal électrique au moment du défaut comprend l'obtention, au niveau du poste source, de mesures des courants et tensions pour les trois phases du départ en défaut et l'application d'une transformation de Fortescue aux mesures pour obtenir des valeurs de composantes symétriques au niveau du poste source.

3. Procédé selon la revendication 2, dans lequel l'examen d'un tronçon comprend l'utilisation d'un modèle matriciel du réseau pour, à partir des valeurs des composantes symétriques au niveau du poste source, estimer :

    - la tension et le courant de la phase affectée du défaut au niveau de la tête du tronçon ;
    - un courant homopolaire au niveau de la tête du tronçon ; et
    - les composantes symétriques en amont et en aval de la queue du tronçon.

4. Procédé selon la revendication 3, dans lequel l'estimation (CAL1, CAL2, CAL3) du courant de défaut est réalisée à partir des composantes symétriques en amont et en aval de la queue du tronçon et dans lequel le calcul de la distance du défaut depuis la tête du tronçon est réalisée à partir de la tension et du courant de la phase en défaut au niveau de la tête du tronçon, du courant homopolaire au niveau de la tête du tronçon et du courant de défaut estimé.

5. Procédé selon la revendication 4, dans lequel l'estimation du courant de défaut est réalisée à partir des composantes symétriques homopolaires en amont et en aval du défaut.

6. Procédé selon l'une des revendications 1 à 5, dans lequel l'examen d'un tronçon comprend en outre une estimation d'une résistance de défaut à partir de la tension et du courant de la phase en défaut au niveau de la tête du tronçon, du courant homopolaire au niveau de la tête du tronçon, du courant de défaut estimé et de la distance estimée du défaut.

7. Procédé selon l'une des revendications 1 à 5 dans lequel le réseau est un réseau à neutre compensé, comprenant en outre :

- l'estimation, pour chaque tronçon du départ en défaut pour lequel une solution de localisation du défaut est identifiée, d'une première résistance de défaut à une fréquence fondamentale du réseau et d'une deuxième résistance de défaut à une fréquence dominante d'oscillations transitoires lors de l'apparition du défaut ;
- la localisation du défaut à partir de la solution de localisation du défaut identifiée pour le tronçon présentant le plus faible écart entre la première et la deuxième résistance de défaut.

8. Produit programme d'ordinateur comprenant des instructions qui, lorsque le programme est exécuté par un ordinateur, conduisent celui-ci à mettre en œuvre le procédé selon l'une des revendications 1 à 7.

9. Appareil de localisation d'un défaut d'un réseau de distribution électrique, comprenant un processeur configuré pour mettre en œuvre le procédé selon l'une des revendications 1 à 7.

10. Poste de transformation électrique, comprenant un appareil selon la revendication 9.


**Patentansprüche**

1. Verfahren zur Lokalisierung eines Fehlers, der eine Phase eines Fehlerabgangs in einem Stromverteilungsnetzes betrifft, das die folgenden Schritte umfasst:

- Erhalten eines elektrischen Signals zum Zeitpunkt des Fehlers, wobei das elektrische Signal an einer Quellstation (PS) des Netzes ausschließlich für den Fehlerabgang gemessen (MES) wird;
- Untersuchen von Abschnitten (TR1, TR2, TR3, TR4, TRn) des Fehlerabgangs, wobei jeder Abschnitt einen Anfang und ein Ende aufweist und die Untersuchung eines Abschnitts umfasst:

    ◦ Schätzen, anhand des erhaltenen elektrischen Signals, eines Fehlerstroms am Ende des Abschnitts und Berechnen einer Entfernung des Fehlers ab dem Anfang des Abschnitts;
    ◦ Berechnen einer Abweichung zwischen der berechneten Entfernung und einer Länge, die den Anfang vom Ende des Abschnitts trennt und;
    ◦ Identifizieren oder Nichtidentifizieren einer Lösung zur Lokalisierung des Fehlers in Abhängigkeit von dieser Abweichung.

2. Verfahren nach Anspruch 1, wobei der Schritt des Erhaltens eines elektrischen Signals zum Zeitpunkt des Fehlers das Erhalten von Strom- und Spannungsmessungen für die drei Phasen des Fehlerabgangs an der Quellstation und das Anwenden einer Fortescue-Transformation auf die Messungen umfasst, um Werte symmetrischer Komponenten an der Quellstation zu erhalten.

3. Verfahren nach Anspruch 2, wobei die Untersuchung eines Abschnitts die Verwendung eines Matrixmodells des Netzes umfasst, um ausgehend von den Werten der symmetrischen Komponenten an der Quellstation zu schätzen:

- die Spannung und den Strom der vom Fehler betroffenen Phase am Anfang des Abschnitts;
- einen Nullstrom am Anfang des Abschnitts; und
- die symmetrischen Komponenten vor und nach dem Ende des Abschnitts.

4. Verfahren nach Anspruch 3, wobei die Schätzung (CAL1, CAL2, CAL3) des Fehlerstroms anhand der symmetrischen Komponenten vor und nach dem Ende des Abschnitts erfolgt und wobei die Berechnung der Entfernung des Fehlers ab dem Anfang des Abschnitts anhand der Spannung und des Stroms der Fehlerphase am Anfang des Abschnitts, des Nullstroms am Anfang des Abschnitts und des geschätzten Fehlerstroms erfolgt.

5. Verfahren nach Anspruch 4, wobei die Schätzung des Fehlerstroms anhand der symmetrischen Nullstromkomponenten vor und hinter dem Fehler erfolgt.

6. Verfahren nach einem der Ansprüche 1 bis 5, wobei die Untersuchung eines Abschnitts ferner eine Schätzung eines Fehlerwiderstands anhand der Spannung und des Stroms der Fehlerphase am Anfang des Abschnitts, des Nullstroms am Anfang des Abschnitts, des geschätzten Fehlerstroms und der geschätzten Entfernung des Fehlers umfasst.

7. Verfahren nach einem der Ansprüche 1 bis 5, wobei das Netz ein kompensiertes Sternpunktnetz ist, das ferner umfasst:

- die Schätzung, für jeden Abschnitt des Fehlerabgangs, für den eine Fehlerlokalisierungslösung identifiziert wurde, eines ersten Fehlerwiderstands bei einer Grundfrequenz des Netzes und eines zweiten Fehlerwiderstands bei einer dominanten Frequenz von transienten Schwingungen beim Auftreten des Fehlers;
- die Lokalisierung des Fehlers anhand der identifizierten Fehlerlokalisierungslösung für den Abschnitt, der die geringste Abweichung zwischen dem ersten und dem zweiten Fehlerwiderstand aufweist.

8. Computerprogrammprodukt, das Befehle umfasst, die, wenn das Programm von einem Computer ausgeführt wird, bewirken, das Verfahren nach einem der Ansprüche 1 bis 7 ausgeführt wird.

9. Vorrichtung zur Lokalisierung eines Fehlers in einem Stromverteilungsnetz, umfassend einen Prozessor, der zur Durchführung des Verfahrens nach einem der Ansprüche 1 bis 7 konfiguriert ist.

10. Stromtransformatorstation, die eine Vorrichtung nach Anspruch 9 umfasst.

**Claims**

1. A method for locating a fault affecting a phase of a faulted feeder in an electrical distribution network, comprising the following steps:

- obtaining an electrical signal at the time of the fault, the electrical signal being measured (MES) at a source substation (PS) of the network solely for the faulty feeder;
- examining sections (TR1, TR2, TR3, TR4, TRn) of the faulty feeder, each section having a head and a tail, and the examination of a section comprising:

  ◦ based on the obtained electrical signal, estimating a fault current at the tail of the section and calculating a distance of the fault from the head of the section;
  ◦ calculating a deviation between the calculated distance and a length separating the head from the tail of the section; and
  ◦ based on said difference, determining whether or not a fault location solution is identified.

2. A method according to claim 1, wherein the step of obtaining an electrical signal at the time of the fault comprises obtaining, at the source substation, measurements of the currents and voltages for the three phases of the faulted feeder and applying a Fortescue transformation to the measurements to obtain values of symmetrical components at the source substation.

3. A method according to claim 2, wherein the examination of a section comprises using a matrix model of the network to estimate, based on the values of the symmetrical components at the source substation:

- the voltage and current of the phase affected by the fault at the head of the section;
- a zero-sequence current at the head of the section; and
- the symmetrical components upstream and downstream of the section's tail.

4. A method according to claim 3, wherein the estimation (CAL1, CAL2, CAL3) of the fault current is performed based on the symmetrical components upstream and downstream of the tail of the section, and wherein the calculation of the distance of the fault from the head of the section is performed based on the voltage and current of the faulty phase at the head of the section, the zero-sequence current at the head of the section, and the estimated fault current.

5. A method according to claim 4, wherein the estimation of the fault current is performed based on the symmetrical zero-sequence components upstream and downstream of the fault.

6. A method according to any one of claims 1 to 5, wherein the examination of a section further comprises estimating a fault resistance based on the voltage and current of the faulty phase at the head of the section, the zero-sequence current at the head of the section, the estimated fault current, and the estimated distance of the fault.

7. A method according to any one of claims 1 to 5, wherein the network is a compensated neutral network, further comprising:

   - estimating, for each section of the faulted feeder for which a fault location solution is identified, a first fault resistance at a fundamental frequency of the network and a second fault resistance at a dominant frequency of transient oscillations upon the occurrence of the fault;
   - locating the fault based on the fault location solution identified for the section exhibiting the smallest difference between the first and second fault resistances.

8. A computer program product comprising instructions which, when the program is executed by a computer, cause the computer to implement the method according to one of claims 1 to 7.

9. Apparatus for locating a fault in an electrical distribution network, comprising a processor configured to implement the method according to one of claims 1 to 7.

10. An electrical substation, comprising an apparatus according to claim 9.

FIG. 1

# FIG. 2

FIG. 3

EP 4 343 344 B1

FIG. 4

EP 4 343 344 B1

FIG. 5

# RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- FR 3028620 B1

**Littérature non-brevet citée dans la description**

- **R. MARGUET** ; **B. RAISON**. Fault distance localization method for heterogeneous distribution networks. *2014 IEEE PES General Meeting | Conference & Exposition*, 2014, 1-5

- **T. D. LE** ; **M. PETIT**. Earth fault location based on a Modified Takagi Method for MV distribution networks. *2016 IEEE International Energy Conference (ENERGYCON)*, 2016, 1-6